# EUROPÄISCHE PATENTANMELDUNG

(11) **EP 0 994 201 A2**
(43) Veröffentlichungstag der Anmeldung: **19.04.2000**
(21) Anmeldenummer: 99120242.5
(22) Anmeldetag: 11.10.1999
(51) Int. Cl.: C23C 14/02, C23C 16/02, C23F 1/00

(54) **Verfahren zur Oberflächenbehandlung von Werkzeugen**

(30) Priorität: 17.10.1998 DE 19848025
(71) Anmelder: Verschleiss- Schutz-Technik, Keller GmbH & Co. KG, 73650 Schopfheim (DE)
(72) Erfinder: Keller, Klaus, 4612 Wangen (CH); Koch, Fritz, 79618 Rheinfeldern-Degerfelden (DE)
(74) Vertreter: Patentanwälte Westphal, Mussgnug & Partner

(57) **Zusammenfassung**

Es wird ein Verfahren zur Oberflächenbehandlung von Werkzeugen aus Werkzeugstahl, in deren Stahlmatrix Primärkarbide eingelagert sind, beschrieben. Dabei werden an der Oberfläche befindliche Primärkarbide unter Bildung einer punktförmig vertieften Oberfläche abgelöst oder ganz herausgelöst, und auf dieser eine Hartstoffschicht abgeschieden. Die Erfindung beschreibt weiterhin Werkzeuge aus Werkzeugstahl, in dessen Stahlmatrix Primärkarbide eingelagert sind, worin die Primärkarbide wesentlich abgesenkt sind und eine Hartstoffschicht darauf aufgetragen ist.

## Beschreibung

Die vorliegende Erfindung betrifft ein Verfahren zur Oberflächenbehandlung von Werkzeugen aus Werkzeugstahl, in deren Matrix Primärkarbide eingelagert sind und Werkzeuge, in deren Stahlmatrix Primärkarbide eingelagert sind, mit einer behandelten Oberfläche.

Seit einigen Jahrzehnten werden Hochleistungswerkzeuge zum Zwecke höchster Verschleißbeständigkeit mit Hartstoffschichten versehen. Sie bestehen z. B. aus Nitriden, Karbiden, Karbonitriden und Boriden, gebildet mindestens aus einem Metall der Gruppe Titan, Zikon, Chrom, Wolfram, Tantal, Vanadium, Niob und Hafnium, mit mindestens einem Leichtelement wie z. B. Stickstoff, Kohlenstoff und oder Bor. Die Schichtabscheidung erfolgt vorzugsweise nach der CVD-Technik (CVD für ***C***hemical ***V***apour ***D***eposition) oder PVD-(PVD für ***P***hysical ***V***apour ***D***eposition).

Die Werkzeuge werden vorzugsweise aus ledeburitischen Kaltarbeitsstählen und Hochleistungsschnellstählen (HSS) gefertigt. Diese Stähle lassen sich durch geeignete Warmbehandlungen auf hohe Härte einstellen und verfügen auch über ( in der Stahlmatrix ) eingelagerte, sehr harte Karbide, welche nach (großen) Primär- und (kleinen) Sekundärkarbiden zu unterscheiden sind. Diese Karbide, insbesondere die Primärkarbide, z. B. vom Typ M₇C₃, verleihen diesen Werkzeugstählen zusätzliche Verschleißbeständigkeit, so daß normalerweise ein großer Karbidanteil durch gezielte Stahllegierung angestrebt wird.

Während die rundlichen, nur wenige Mikrometer kleinen Sekundärkarbide in der Stahlmatrix relativ gleichmäßig verteilt, bruchmechanisch also unkritisch sind, erlangen die um 2 bis 3 Größenordnungen voluminöseren Primärkarbide durchaus bruchmechanische Relevanz. Dies gilt um so mehr, wenn sich die (meist) grobstückigen Primärkarbide zu ausgeprägten (Karbid)-Zeilen formieren und/oder zu (Karbid)-Nestern zusammenballen. Infolge der unterschiedlichen physikalischen Werkstoffeigenschaften (die Stahlmatrix verhält sich (mikro-)plastisch / Karbide bei wesentlich höherem E-Modul jedoch nur linear-elastisch, also nichtplastisch) entstehen schon bei mäßiger äußerer Belastung Spannungsspitzen, welche funktionsrelevante Risse vorzeitig auszulösen vermögen.

Diese Primärkarbide, insbesondere solche im Bereich hoch beaspruchter Oberflächen sind also stets kritisch zu wertende Ausgangspunkte für (spröde) Werkzeugbrüche. Sie beinhalten stets ein Defektpotential, welches durch die spanabhebende Oberflächenbearbeitung insofern noch verstärkt wird, als der Anschnitt der spröden Karbide in der Scherebene des Spans brüchig-rauhe Karbidflächen mit vereinzelten Karbidlockerungen hinterläßt. Im Bereich größerer Karbidanhäufungen bilden sich bröselig-zerrüttete, wenig tragfähige Defektstellen, welche in hochbelasteten Gleitflächen erste, mikroskopisch kleine Oberflächenschäden verursachen. Diese weiten sich vor allem in den Hochlastzonen d. h. in Vorsprüngen, Radien oder Schnittkanten rasch aus, gefolgt von plötzlichem Werkzeugversagen.

Diese mikroskopisch kleinen Defektstrukturen sind in sämtlichen schmelzmetallurgisch hergestellten, karbidreichen Stählen nach der Zerspanung vorhanden. Sie lassen sich durch Nacharbeit, wie z. B. Läppen oder Polieren in gewissen Grenzen abschwächen, kaum jedoch gänzlich eliminieren. Für "normale" Beanspruchung ausgelegte, nicht beschichtete Gleitflächen vermag eine solche Nacharbeit durchaus zu genügen, da die störenden Defekte im Rahmen eines Einlaufvorgangs weiter reduziert werden, und nach dem Einlaufen eine durchaus auskömmliche Belastungsfähigkeit (Trainiereffekt) vorliegt.

Werden die Gleitlächen jedoch beschichtet, so sind Einlaufvorgänge gerade wegen der aufgebrachten hochverschleißbeständigen Schutzschicht nicht möglich. Vielmehr geht unter diesen völlig veränderten Bedingungen von den oberflächlich angeschnittenen, großen (Primär-)Karbiden im Kontakt mit der aufliegenden Hartstoffschicht eine zusätzliche Störgröße aus, mit folgenden Aspekten:
1) Schichthartstoffe verfügen, ähnlich den Karbiden, über signifikant abweichende Werkstoffeigenschaften im Vergleich zu Stahl-Eisenwerkstoffen ( wesentlich höherere E-Moduli, geringere Ausdehnungskoeffizienten usw. ). Diese Schichten verhalten sich unter Last ebenfalls nur linear elastisch, nicht jedoch plastisch. Wegen des hohen E-Moduls sind rißfreie Schichtauslenkungen im elastischen Bereich entsprechend limitiert. Daraus folgt, daß bei relativ geringer Schichtauslenkung eine Grenzlast erreicht wird, bei der in der Stahlmatrix noch hinlänglich elastisches Verhalten vorliegt, in der Hartstoffschicht jedoch schon Rißbildung eintritt. Dieses, aus der Metall-Keramik-Fügetechnik bestens bekannte, verbundwerkstoff-typische Phänomen erzwingt, den Verbundkörper *Schicht-Stahl* trotz der mikroskopisch kleinen Dimensionen als äußerst anspruchsvolles Konstruktionselement zu behandeln, sofern extreme Belastungsfähigkeit und Verschleißbeständigkeit gefordert sind.
2) Da Hartstoffschichten auf Stahl stets unter (hohen) tangentialen Druckeigenspannungen stehen, verfügen sie *senkrecht* zur Oberfläche über eine beachtliche Möglichkeit, *vertikale* Schichtauslenkungen rißfrei zu ertragen - unter Abbau der tangentialen Druckeigenspannungen im elastischen Bereich. Eine *vertikal* auf einen Oberflächenpunkt wirkende Überlast, die im darunterliegenden Grundwerkstoff bereits eine plastische Deformation verursacht, kann von der Schicht also solange rißfrei ertragen werden, wie im Bereich maximaler Auslenkung tangentiale Druckeigenspannungen noch vorhanden sind. Dies gestattet, daß sich Unebenheiten in hoch belasteten Gleitflächen dauerhaft einebnen können, wobei die keramische Natur der Hartstoffschichten ein sonst übliches Verschweißen der überlasteten Kontaktstellen verhindert. Dem System liegt also eine gewisse, schichtspezifische, selbstständige Tragbildverbesserung zugrunde, welche die extreme Belastungsfähigkeit solcher Hartstoffschichten teilweise erklärt.
3) Im Gegensatz zu diesem generell vorteilhaften Schichtverhalten unter *vertikaler* Überlast ist die Wirkung einer *tangential* in die Schicht eingeleiteten Kraft unterschiedlich zu werten. Einerseits werden die durch hohe, lokale Reibkräfte induzierten, *horizontalen* Schichtauslenkungen infolge der Schichtdrukkeigenspannung in Kraftrichtung sehr günstig aufgenommen. Andererseits treten zu seitlich weniger belasteten und somit auch weniger ausgelenkten Nachbarbereichen Scherbewegungen auf, welche von der Schicht nur innerhalb linear-elastischer Grenzen rißfrei ertragen werden können. Infolge des hohen E-Moduls der Schichtmaterialien sind diese Relativbewegungen jedoch kleiner als in der Stahlmatrix, so daß eine lokale, *horizontale* Überlastung relativ rasch Rißbildungen in der Schicht zur Folge haben kann. Dies gilt um so mehr, als der Grundwerkstoff - nicht zuletzt auch wegen des geringeren E-Moduls - weiterhin elastisch verschiebbar ist, ganz ungeachtet der Formänderungsreserve im plastischen Bereich.
4) Die Betrachtungen unter 2) und 3) treffen nur für den Fall zu, daß die Hartstoffschicht mit einer homogenen Stahlmatrix verbunden ist. Sind jedoch karbidische Einschlüsse in der Randzone der Stahlmatrix eingebettet, so gelten diese Aspekte um so weniger, je größer die Karbide bzw. Karbidformationen (im Verhältnis zur Schichtdicke) sind. Erreichen die Karbiddiagonalmaße die Größenordnung von etwa zweifacher Schichtdicke, so wirken diese im Grundwerkstoff verankerten Karbide ähnlich unverrückbaren Pfeilern in einer Strömung. Sie komplizieren den Spannungszustand zwischen Schicht, Karbid und Grundwerkstoff erheblich, unter signifikantem Anstieg des Defektpotentials und der Neigung zu Rißbildungen. Insbesondere bei Schwellast, und ganz besonders bei Wechsellast wirken sich die Spannungen im Kontakt mit Großkarbiden bruchauslösend aus. Zwar werden die *karbidischen* "*Fixpunkte*" bisweilen als willkommene Ankerpunkte der Schicht zur Steigerung der Haftfestigkeit angesehen, doch trifft dies nur für kleine Karbidgrößen im Bereich der Schichtdicke zu , d.h. nur für die oben erwähnten Sekundärkarbide.
5) Weiterhin nachteilig ist, daß bei der Feinbearbeitung der Oberflächen, insbesondere durch Polieren, die Karbide infolge ihrer höheren Härte langsamer abgetragen werden als die gehärtete, aber dennoch weichere Stahlmatrix, so daß nach längerem Polieren ein erhabenes, sog. Karbidrelief entsteht. Dieses Relief bildet sich natürlich auch in der Schichtoberfläche ab. Solche Erhöhungen (oft in der Größenordnung der Schichtdicken) werden vor der Beschichtung selten erkannt, treten aber auf der Schicht um so auffälliger hervor, je größer das Karbid bzw. die Karbidkonzentration ist. Höhere Reliefstrukturen vermögen den Traganteil drastisch zu verringern. Infolge des Materialstaus und der wechselnden Schubkräfte werden die Überhöhungen gelockert, brechen schließlich aus, und ziehen oft - als typische Sekundärschädigungen - Furchen durch die Schicht. Die ausgebrochenen Schadstellen bilden Ansatzpunkte für Kaltaufschweißungen, welche Riefen und Freßbahnen am Gleitpartner verursachen.
6) Eine ähnliche Reliefstruktur kann auch - mit etwas schwächerer Wirkung entstehen, wenn z. B. in PVD-Prozessen zwecks besserer Schichthaftung das der eigentlichen Beschichtungsphase vorausgehende Sputtercleaning zu intensiv durchgeführt wird. Dies liegt darin begründet, daß die Schwellenergie für die Materialalabtragung bei Karbiden durchwegs höher liegt als bei der Stahlmatrix und somit die Stahlmatrix rascher abgesputtert wird.
7) Berücksichtigt man noch das anfangs beschriebene, zerspanungbedingte Defektpotential mit brüchigen und teils gelockerten Primärkarbiden, insbesondere im Bereich abgewinkelter Flächenübergänge, vor allem aber in kleinen Radien, vorstehenden Ecken und Schnittkanten, so läßt sich folgern, welche Defektintensität dem Verbundsystem innewohnt.

Aufgrund dieser Defektbetrachtungen könnte gefolgert werden, daß primärkarbidfreie Stähle grundsätzlich günstigere Voraussetzungen für die Tragfunktion böten. Zu bedenken ist allerdings, daß diese Stähle weder genügend hart, noch ausreichend temperaturbeständig sind, und daher bei besonders hohen Beanspruchungen, wie bei Hochleistungswerkzeugen üblich, den Hartstoffschichten nicht die erforderliche Abstützung geben.

Der vorliegenden Erfindung liegt die Aufgabe zugrunde, die aufgezeigten, primärkarbidbedingten Defektpotentiale zu beseitigen und ein Werkzeug zur Verfügung zu stellen, das ein extrem belastungsfähiges und verschleißbeständiges Schichtsystem höchster Zuverlässigkeit aufweist.

Diese Aufgaben wird durch ein Verfahren zur Oberflächenbehandlung von Werkzeugen mit den Merkmalen des Patentanspruchs 1 und durch ein Werkzeug mit den Merkmalen gemäß Patentansprüchen 13 und 18 gelöst.

Die Unteransprüche definieren bevorzugte Ausführungsformen des Anmeldungsgegenstands.

Die vorliegende Erfindung betrifft ein Verfahren zur Oberflächenbehandlung von Werkzeugen aus Werkzeugstahl, in deren Stahlmatrix Primärkarbide eingelagert sind, welches dadurch gekennzeichnet ist, daß an der Oberfläche aufgedeckte und/oder angeschnittene und/oder reliefartig vorstehende Primärkarbide unter Bildung einer punktförmig vertieften Oberfläche abgelöst oder gänzlich herausgelöst werden und auf diese Oberfläche eine ein- oder mehrlagige Hartstoffschicht abgeschieden wird.

Die vorliegende Erfindung betrifft weiterhin ein Werkzeug aus Werkzeugstahl, in dessen Stahlmatrix Primärkarbide eingelagert sind, mit einer behandelten Oberfläche, welches dadurch gekennzeichnet ist, daß im randnahen Stahlbereich die Primärkarbide in vorbestimmtem Maß mindestens um 1 µm bis um die doppelte Schichtdicke abgesenkt oder gänzlich herausgelöst sind und die ein- oder mehrlagige CVD-Hartstoffschicht diese Vertiefungen oder Kavernen zusammen mit Bestandteilen der abgelösten Primärkarbide vollkommen ausfüllt und somit punktförmig verteilte, formschlüssige Schichtverankerungen im Grundwerkstoff vorliegen, welche der Hartstoffschicht zusätzliche Schubwechselfestigkeit und Haftfestigkeit verleihen.

Die vorliegende Erfindung betrifft zudem noch ein Werkzeug aus Werkzeugstahl, in dessen Stahlmatrix Primärkarbide eingelagert sind, mit einer behandelten Oberfläche, welches dadurch gekennzeichnet ist, daß im randnahen Stahlbereich die Primärkarbide in vorbestimmtem Maß mindestens um 1 µm bis 4 µm abgesenkt sind und die PVD-Hartstoffschicht diese Vertiefungen auskleidet oder ausfüllt und somit punktförmig verteilte, formschlüssige Schichtverankerungen im Grundwerkstoff vorliegen, welche der PVD-Hartstoffschicht zusätzliche Schubwechselfestigkeit und Haftfestigkeit verleihen. Um die Tragfestigkeit des Verbundsystems zusätzlich noch zu erhöhen, ist auch eine Mikroverzahnung zwischen Hartstoffschicht und Grundwerkstoff vorgesehen, so wie auch eine Nitrierung des randnahen Stahlbereiches.

In den Zeichnungen werden Querschnittsansichten von Werkzeugoberflächen im einzelen erläutert. Es zeigen:
- Fig. 1: eine schematische Darstellung einer unbehandelten Oberfläche eines Werkzeugs;
- Fig. 2: eine schematische Darstellung, in der ein Primärkarbid elektrolytisch abgetragen wurde;
- Fig. 3: eine schematische Darstellung mit dem im CVD-Prozeß abgetragenen Primärkarbid und Kantenabrundung sowie Wulstbildung nach Karbidabtragung im CVD-Prozeß;
- Fig. 4 und 5: eine schematische Darstellung einer mittels PVD-abgeschiedenen Hartstoffschicht, wobei die PVD-Schicht muldenförmig vertieft und gemäß Fig. 5 mit dem Grundwerkstoff mikroverzahnt ist, wobei der Grundwerkstoff zustätzlich noch nitriert ist;
- Fig. 6 und 7: eine schematische Darstellung einer CVD-Schicht auf einem abgetragenen Primärkarbid, wobei diese gemäß Fig. 7 mit dem Grundwerkstoff mikroverzahnt ist;
- Fig. 8: eine schematische Darstellung einer unbehandelten Schnittkante im Bereich eines beidseitig angeschnittenen und einseitig infolge Spaltbildung gelockerten Primärkarbids;
- Fig. 9: eine schematische Darstellung einer PVD-beschichteten Schnittkante;
- Fig. 10: eine schematische Darstellung einer CVD-beschichteten Schnittkante bzw. eines mit CVD ausgefüllten Spalts;
- Fig. 11: eine schmatische Darstellung eines Karbidreliefs und
- Fig. 12: eine schematische Darstellung eines durch Polieren geglätteten Wulstes.
- Fig. 13: eine schematische Datstellung einer optimal gestalteten PVD-Schicht im Bereich eines Primärkarbids;
- Fig. 14: eine schematische Darstellung einer optimal gestalteten dreilagigen CVD-Schicht im Bereich eines Primärkarbids.

Es ist erfindungsgemäß möglich, die Hartstoffschicht nach dem CVD- oder PVD-Verfahren abzuscheiden. Hier ist allerdings das CVD-Beschichtungsverfahren bevorzugt.

In der CVD-Beschichtung sollen unmittelbar vor Beginn der eigentlichen Beschichtung in ein und demselben thermischchemischen Prozeß spezifisch eingestellte Gase die Primärkarbide chemisch und/oder thermisch auf eine vorbestimmte Tiefe ablösen und oder herauslösen. Die Tiefe beträgt in der Regel mindestens 1 µm bis zweimal Schichtdicke.

Alternativ ist es auch möglich, die Ablösung bzw. Herauslösung in einem der CVD-Beschichtung vorgeschalteten, getrennten Prozeß in flüssigem Medium galvanisch oder chemisch durchzuführen.

Beim PVD-Verfahren werden die Primärkarbide vorher in einem getrennten Prozeß in einem flüssigen Medium galvanisch oder chemisch auf eine vorbestimmte Tiefe abgelöst oder herausgelöst. Die Tiefe soll vorzugsweise im Bereich von 1 µm bis zweimal Schichtdicke liegen.

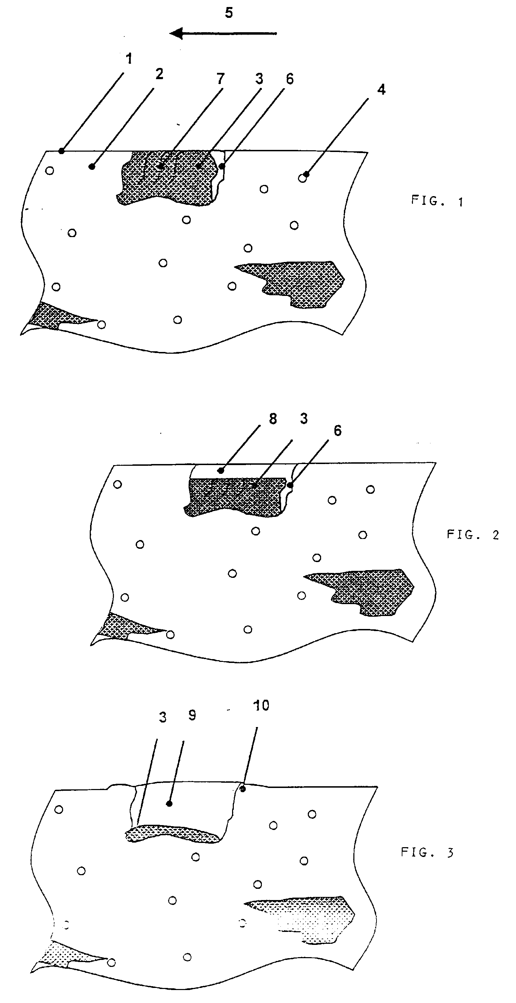

Eine noch unbehandelte Oberfläche eines Werkzeugs ist in Fig. 1 gezeigt. In der Stahlmatrix 2 sind Primärkarbide 3 und Sekundärkarbide 4 eingelagert. Neben dem Primärkarbid befindet sich ein bearbeitungsbedingter Spalt 6, der bis an die Substratoberfläche 1 reicht. Des weiteren sind im Primärkarbid bearbeitungsbedingte Risse 7 ausgebildet, die sich ebenfalls bis zur Substratoberfläche erstrecken. Bezugszeichen 5 gibt die Bearbeitungsrichtung an. Das Primärkarbid kann auch aus der Substratfläche herausragen. Ein solches Karbidrelief 20 ist in Fig. 11 gezeigt.

In dem erfindungsgemäßen Verfahren werden nach der mechanischen Bearbeitung der funktionsrelevanten Arbeitsflächen, d. h. *nach* Zerspanen, Läppen oder Polieren und *vor* der Beschichtung, die angeschnittenen oder aufgedeckten Primärkarbide bis zu einer vorbestimmten Tiefe abgetragen, ggf. auch gänzlich aus der randnahen Stahlmatrix herausgelöst. Dabei kann die Karbidabtragung in einer getrennten, der Beschichtung vorgelagerten Behandlung erfolgen oder - wie ausschließlich nur beim CVD-Prozeß möglich - auch im Beschichtungsprozeß selbst.

Erfolgt die Karbidablösung - wie beim PVD-Verfahren erforderlich - in einer getrennten, dem Beschichtungsprozeß vorgelagerten Behandlung in Flüssigphase, z. B. in alkalischem Elektrolyt, so ist die Zusammensetzung des Elektrolyten so zu wählen, daß vorzugsweise nur die Primärkarbide angelöst bzw. abgetragen werden. Karbidabtrag und dessen Intensität, d. h. Geschwindigkeit und Abtragstiefe, werden über die chemische Zusammensetzung und Konzentration des Elektrolyten sowie über Stromstärke, Badtemperatur und Tauchzeit gesteuert. In Fig. 2 ist der Bereich 8 eines elektrolytisch abgetragenen Primärkarbids gezeigt. Nachteil der Karbidabtragung in Flüssigphase ist vor allem, daß das Behandlungsgut nachträglich verschiedene Reinigungs- bzw. Neutralisierungsbäder mit abschließender Intensivtrocknung durchlaufen muß, wodurch die zu beschichtenden Oberflächen rosten bzw. unkontrolliert kontaminiert werden können, was der Schichthaftfestigkeit nicht zuträglich ist.

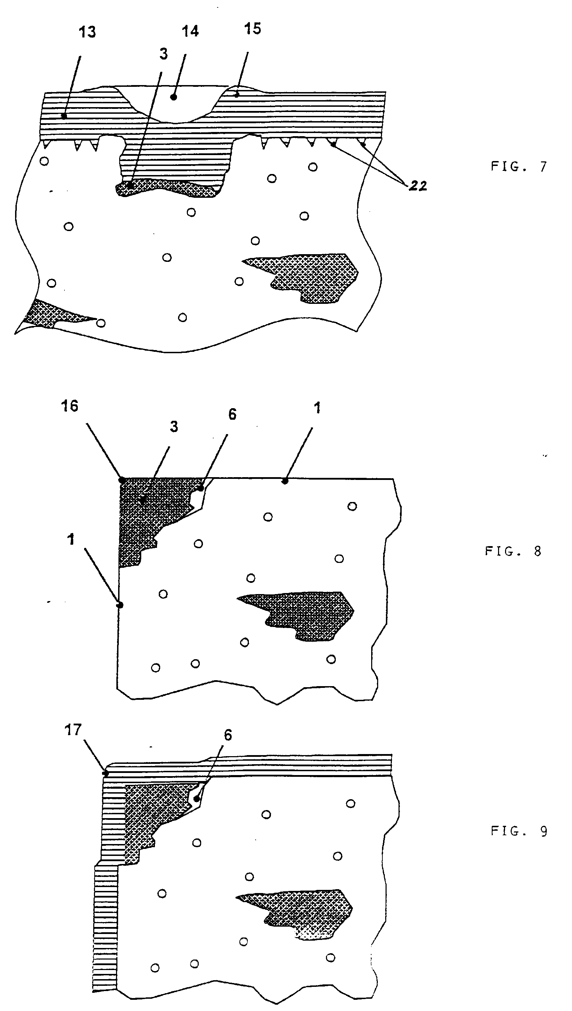

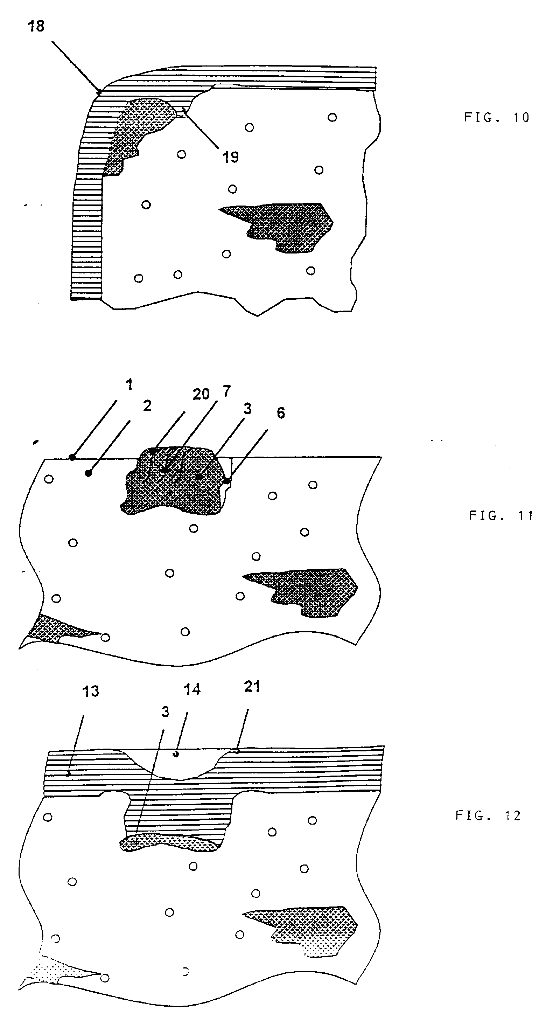

PVD-abgeschiedene Schichten werden in den Fig. 4 und 5 gezeigt. Die abgeschiedene Hartstoffschicht 11 befindet sich auf der Substratoberfläche und bildet muldenförmige Vertiefungen 12. Typisch für das PVD-Verfahren ist, daß der Spalt 6 nicht oder nur geringfügig ausgefüllt, also nicht 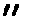 zuzementiert" wird, so daß die Kerbwirkung verstärkt weiter besteht. Zusätzlich sind in Fig. 5 eine tragfähigkeitssteigernde Mikroverzahnung 22 und Nitrierzone 23 dargestellt. Fig. 8 zeigt eine unbeschichtete Schnittkante 16 mit ungünstig liegendem Primärkarbid und bearbeitungsbedingtem Spalt 6. Die in Fig. 9 gezeigte PVD-beschichtete Schnittkante 17 läßt zwar das vorteilhafterweise durch Teilablösung zurückversetzte Primärkarbid erkennen, zeigt allerdings auch wie in Fig. 4 und 5, daß Spalte nicht ausgefüllt bzw. 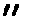 zuzementiert" werden, wodurch hier eine besonders kritische Defektformation entsteht.

Bei der CVD-Beschichtung hingegen kann die Karbidabtragung direkt in den Beschichtungsprozess als "*in situ*" - *Startphase* integriert werden. Karbidauflösende Medien sind hier erhitzte, schnellströmende, hochaktive und ätzende Prozeßgase. Ihre Zusammensetzung kann in einer Gasversorgungseinheit vorteilhafterweise beliebig variiert werden, so daß selektiv und sequentiell auf die Erfordernisse des Behandlungsgutes eingegangen werden kann. Daraus resultieren folgende CVD-typischen Vorteile :
a) Gegenüber der Flüssigphase ermöglicht die Gasphase, daß das gasförmige Reaktionsmedium auch in feinste Risse und tiefste Spalten eindringt, so daß diese vollständig dekontaminiert, entpassiviert und verrundet werden, was die Qualität der Schichtanbindung wesentlich verbessert.
b) Aus 1) folgt ferner, daß sich angerissene, zersplitterte oder gelockerte Karbide wegen des umfassenderen Kontaktes - gerade auch in diesen Rissen und Spalten - im gasförmigen Reaktionsmedium schneller abtragen lassen, und sich die Defektreduktion vor allem auf die defektträchtigsten Stellen konzentriert.
c) Die beliebige Variation der karbidablösenden Prozeßgase ermöglicht auch, Wände und Ränder der ausgehöhlten Karbidnester bzw. Karbidkavernen mit Legierungsbestandteilen der abgelösten Karbide und der Stahlmatrix anzulegieren und feinste Risse zu *versiegeln*, sowie scharfe Kerben, Ecken und Kanten abzurunden bzw. auszufüllen. Gleich einer "Versiegelung" werden bruchmechanisch günstige Voraussetzungen für die nachfolgende Beschichtung und Schichteinlagerung in diese Vertiefungen geschaffen.
d) Der Karbidablösungsphase kann gleichzeitig oder zeitlich leicht versetzt auch eine Übergangsphase ( in situ ) überlagert werden, in der Karbidablösung und Schichtbildung gleichzeitig oder zeitlich versetzt erfolgen, z. B. mit dem Vorteil, den Effekt des Anlegierens, Versiegelns und Ausglättens gemäß c) zu unterstützen, und/oder die Stahlmatrix im voraus zu beschichten.

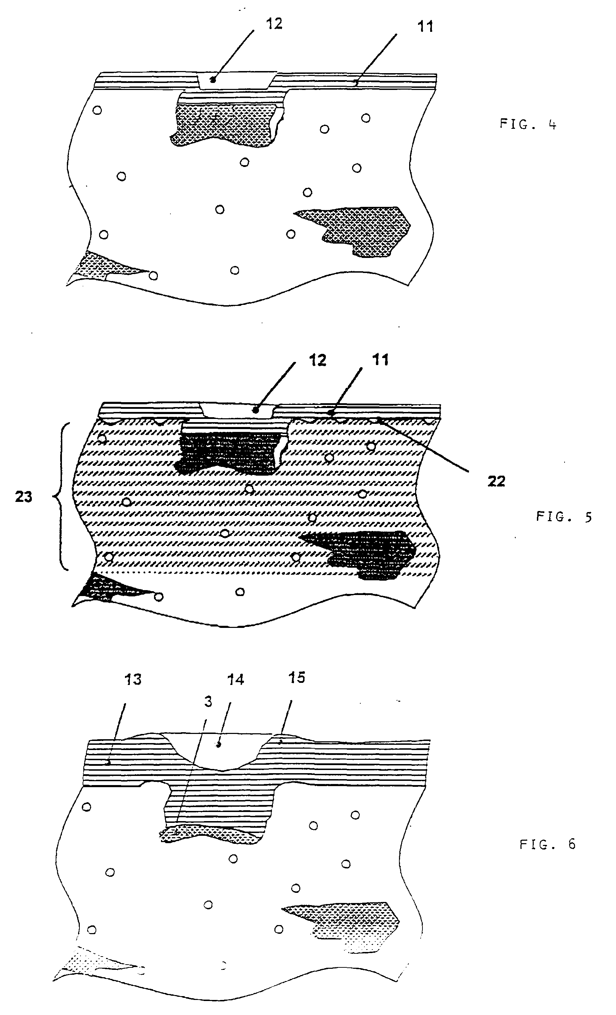

Fig. 3 veranschaulicht die Vorteile der Karbidabtragung im CVD-Verfahren. Im Bereich 9 des abgetragenen Primärkarbids sind ebenfalls die Kanten 10 unter Wulstbildung abgerundet.

Durch die Karbidablösung entstehen punktförmige bis kleinflächige Vertiefungen in der sonst unveränderten Arbeitsfläche, wobei die Absenktiefe der Karbide abhängig von Schichtdicke, Beschichtungsverfahren, Karbidformation und Beanspruchung zu wählen ist. Die Absenktiefe sollte in der Regel nicht wesentlich über 30 % bis 200 % der Schichtdikke hinausgehen, wobei Absenkungen um etwa 1 bis 2 µm die untere Grenze darstellen. Solche Beträge vermögen durchaus schon die Nachteile einer Reliefbildung gemäß 5) und 6) ausreichend zu mildern, und der Schicht bereits eine gewisse zusätzliche Abstützung in den Vertiefungen zu geben.

Eine CVD-Schicht nach Karbidabtragung ist in den Fig. 6 und 7 gezeigt. Die CVD-Schicht 13 ist etwa um das zweibis dreifache dicker als die PVD-Schicht und bildet Mulden 14 aus. Ein Wulst 15 ist auf die Schichtoberfläche übertragen worden. In Fig. 7 ist zusätzlich die Mikroverzahnung 22 zwischen Schicht und Grundwerkstoff dargestellt.

So lassen sich auch in Schnittkanten ungünstig eingelagerte Primärkarbide mit CVD weniger ausbruchgefährdet beschichten. Aus Fig. 10 ist zu entnehmen, daß eine mit CVD-beschichtete Schnittkante 18 bzw. ein darin eingelagertes Primärkarbid vorteilhaft abgerundet ist. Des weiteren ist ein ehemaliger Spalt 6 zu einem ausgerundeten Spalt 19 erweitert und mit einer CVD-Schicht vollständig ausgefüllt worden, wodurch das verkleinerte und zurückversetzte Primärkarbid nicht nur entlastet, sondern auch vollständig 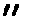 einzementiert" wird.

Eventuell auftretende Wülste 15 in Fig. 6 und 7 lassen sich ohne weiteres durch Diamantpolieren glätten. Dieses ist in Fig. 12 gezeigt, worin ein ehemaliger Wulst 15 unter Bildung einer verrundeten Kante 21 geglättet worden ist.

Je nach Schichtdicke können über den ausgelösten Karbiden flache Absenkungen in der Schichtoberfläche wahrgenommen werden, welche sich vorteilhafterweise als Schmierstoffdepots zur Aufnahme flüssiger oder fester Schmierstoffe eignen. Diese flachmuldigen Absenkungen z. B. gemäß Fig. 4 bis 7 und 12 verbessern die Gleitreibungsverhältnisse nachhaltig, insbesondere unter Bedingungen der Minimalmengen- oder Mangelschmierung. Bei wenigen Mikrometer dünnen (PVD)-Schichten ist die Karbidabsenktiefe begrenzt, so daß eine völlige Herauslösung der Primärkarbide nicht ratsam ist, und somit das Defektpotential nicht im Rahmen der theoretischen Möglichkeiten reduziert werden kann. Auch die Tiefe der Schmierstoffdepots läßt sich dann nicht optimal einstellen.
e) Die CVD-Beschichtungstechnik vermag auch in eng verwinkelten und tiefen Kavernen Hartstoffschichten zusammenhängend abzuscheiden, so daß stets vollständig ausgekleidete oder ausgefüllte Karbidnester vorliegen, wie in Fig. 6, 7 und 10 zu erkennen ist. Zusammen mit den unter c) und d) erläuterten Maßnahmen der Kerbwirkungsunterdrückung entstehen somit bestmögliche Voraussetzungen für bruchmechanisch minimierte Schichtverankerungen. Ein in der Kaverne eingeschlossener, periodisch hoch komprimierter Schmierstoff kann somit in den nicht mehr vorhandenen Kerben und Spalten und wegen der Hartstoffschicht keine kritische Keilwirkung oder Kavitation entfalten, welche sonst bevorzugt unter der Schicht ansetzen und erste Schichtabsprengungen verursachen würden. Gerade in verzweigten Kavernen ehemaliger Karbidkonzentrationen bietet dieses CVI-typische ( ***C***hemical ***V***apour ***I***nfiltration ) Auskleidungsvermögen der CVD-Beschichtungstechnik hohe Sicherheit gegen vorzeitige Schichtschädigungen.
f) Die CVD-Beschichtungstechnik gestattet dank des CVI-typischen Abscheidungsverhaltens, Schichtmaterial sogar in den feinsten Spalten und Rissen zu deponieren, da diese gemäß a) und b) vor der Beschichtung nicht nur verschlossen, sondern tragfest mit Schichtmaterial auszementiert werden. Angerissene, brüchige oder gelockerte Karbide werden dadurch längs der gebildeten Risse und/oder Spalten angelöst und gem. Fig. 10 und Bezugszeichen 19 wieder fest verbunden bzw. in die Stahlmatrix" einzementiert". Etwaige Kerb- und Keilwirkungen werden somit weiter abgebaut, wodurch sich die eingangs beschriebenen, primärkarbid-bedingten Defektpotentiale signifikant reduzieren lassen.
g) Eine Besonderheit der CVD-Beschichtungstechnik ist ferner, daß der eigentlichen Schichtabscheidung auch eine thermische und/oder chemische und/oder thermochemische Zwischenbehandlung im gleichen Prozeß (in situ) vorgelagert werden kann. Sie gestattet variantenreiche Konditionierungen der Grundwerkstoffoberfläche, so daß z. B. in einer zusätzlichen Prozeßphase auch eine gezielte Mikroaufrauhung der Stahlmatrix duchgeführt werden kann, und zwar nach der Karbidabtragung und vor der Beschichtung. Sie begünstigt wie in Fig. 7 dargestellt, zu Beginn des Schichtwachstums die Bildung einer sehr fein ausgebildeten Mikroverzahnung 22 zwischen Stahlmatrix und Schicht und wirkt zusammen mit der Schichtabstützung im Bereich der abgesenkten Primärkarbide zusätzlich haftfestigkeitssteigernd mit zusätzlich erhöhter Schubwechsellastbeständigkeit.

Die unter a) bis f) erläuterten, CVD-spezifischen Besonderheiten gestatten, defektstrategische Maßnahmen in weitesten Grenzen, vor allem grundwerkstoff- und applikationsspezifisch zu ergreifen. So kann auf die Stahlzusammensetzung und Stahlherstellung sowie auf die davon abhängigen Karbidformationen (gegossen, geschmiedet oder gewalzt) auf die Beanspruchungsart (Schnitt-, Stanz-, Blechumform-, Massivumformwerkzeuge) und auf den Werkstückwerkstoff individuell eingegangen werden. So z. B. würde man - gestützt auf den "Versiegelungseffekt" gemäß c) - bei erforderlich scharfer Schnittkante nur eine geringe Karbidablösung vornehmen. Bei extremer Kantenbelastung mit größerem Radius hingegen würde man eine größere Karbidablösung vorsehen, mit entsprechender Auskleidung der entstandenen Spalte, Karbidnester bzw. Kavernen. Bei der Umformung von "klebenden" Blechen, z. B. aus Aluminium, würde man hingegen eine geringere Absenkungstiefe der Karbide bevorzugen und die flachmuldigen Vertiefungen z. B. mit Molybdändisulfid (MoS₂), mit hexagonalem Bornitrid (hBN) oder mit ähnlich reibungsmindernden Festschmierstoffen anreichern, was im gleichen CVD-Prozeß als Abschlußphase durchaus möglich ist.

Bei dem erfindungsgemäßen Werkzeug, das mittels CVD beschichtet worden ist, sind im randnahen Stahlbereich die Primärkarbide in vorbestimmtem Maß mindestens um 1 µm bis um die doppelte Schichtdicke abgesenkt oder ganz herausgelöst. Die ein- oder mehrlagige CVD-Hartstoffschicht füllt diese Vertiefungen oder Kavernen zusammen mit Bestandteilen der ausgelösten Primärkarbide vollkommen aus, so daß punktförmig verteilte, formschlüssige Schichtverankerungen im Grundwerkstoff vorliegen, welche der Hartstoffschicht zusätzliche Schubwechselfestigkeit und Haftfestigkeit verleihen.

Bei dem erfindungsgemäßen Werkzeug aus Werkzeugstahl, das ein defektreduziertes PVD-Schichtsystem aufweist, sind im randnahen Stahlbereich die Primärkarbide in vorbestimmtem Maß mindestens um 1 µm bis 4 µm abgesenkt. Die PVD-Hartstoffschicht kleidet diese Vertiefungen aus, so daß punktförmig verteilte, formschlüssige Schichtverankerungen im Grundwerkstoff vorliegen, welche der PVD-Hartstoffschicht zusätzliche Schubwechselfestigkeit und Haftfestigkeit verleihen. Diese kann durch eine der PVD-Beschichtung vorgeschalteten Nitrierung des randnahen Stahlbereichs zusätzlich noch erhöht werden.

Die PVD-Schicht verfügt auch über eine formschlüssige Mikroverzahnung zwischen Schicht und Stahlmatrix. Des weiteren weist sie über den agbesenkten Karbiden punkt- oder muldenförmige Vertiefungen gemäß DIN 4761-A1B auf, welche Schmiertaschen bilden.

Die nachfolgenden Beispiele sollen die Erfindung erläutern.

### Beispiele:

### Beispiel 1: Karbidabtragung für eine PVD-Beschichtung

Will man die Karbidabtragung für eine PVD-Beschichtung durchführen, so ist dies nur in einem getrennten Prozeß möglich, wobei für die Ablösung von Primärkarbiden z. B. auf Basis M₇C₃ ein Elektrolytbad benutzt wird, wobei der Elektrolyt aus einer alkalischen Lösung, wie 5%iger Natronlauge besteht.

Um eine höhere Tragfestigkeit zu erzielen, kann vor oder nach der Karbidabtragung und stets vor der PVD-Beschichtung eine Mikroaufrauhung bis zu ca. 1/2-Schichtdicke durch Feinkornstrahlen mit Al₂O₃- oder SiC-Partikeln erfolgen. Ebenso kann zusätzlich vor der PVD-Beschichtung eine Plasmanitrierung des randnahen Stahlbereichs bis zu einer Tiefe von ca. 100-facher Schichtdicke vorgenommen werden.

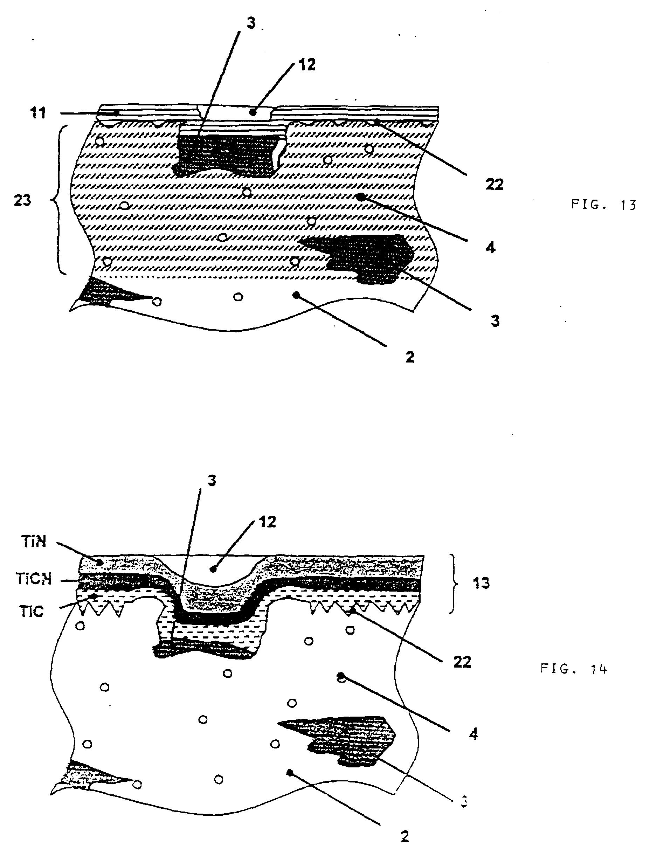

Eine optimal gestaltete Werkzeugoberfläche mit einer PVD-Schicht ist in Fig. 13 schematisch dargestellt.

### Beispiel 2: Karbidabtragung für eine CVD-Beschichtung

Karbidabtragungen für CVD-Beschichtungen werden in situ durchgeführt, d. h. im gleichen Beschichtungsprozeß, in einem Temperaturbereich von 800 - 1000°C in Argon-Wasserstoff-HCl-Gemisch. Zeit, Temperatur und Gaszusammensetzung entscheiden über die Abtragsintensität bzw. Abtragstiefe und über die Anlegierung, Verrundung, Versiegelung und Ausglättung der entstehenden Karbidnester. Als besonders vorteilhaft erwiesen hat sich die Führung des Gasgemisches unter Bedingungen des technischen Vakuum mit entsprechend hohen Gasgeschwindigkeiten. Je nach Chloranteil kann die Anlegierung und Ausrundung bzw. Ausglättung der Karbidnester mehr oder weniger intensiv gestaltet werden. Infolge des Anlegierens der Karbidnestwände mit Bestandteilen des abgelösten Primärkarbids entstehen an den Rändern der Vertiefungen Abrundungen bzw. Auskleidungen, welche jedoch sich leicht wulstförmig in die Substratoberfläche fortsetzen.

Bereits während des Karbidablösungsprozesses läßt sich durch Zugabe eines geeigneten Spendermediums, wie Titantetrachlorid, bereits Titan in die Auskleidungen der Karbidnester mit einlegieren. Dies führt zu rascherem Auskleiden der Karbidnester bzw. zum rascheren Anwachsen einer Schicht aus diesen Vertiefungen. Gleichzeitig bildet sich bereits auf den Stahlmatrixoberflächen eine erste Titan enthaltende Hartstoffschicht. Wird im Anschluß an die Karbidabtragungsphase ein anderes Gasgemisch in den Reaktor eingeführt, welches nun nicht Karbid-spezifisch, sondern Stahlmatrix-spezifisch reagiert, so läßt sich diese punktförmig leicht anätzen, mit Ätzgrübchentiefe bis zu 3 - 5 µm.

Wird nun der eigentliche Beschichtungsprozeß unmittelbar danach gestartet, so legt sich die CVD-Schicht oberflächenparallel über die so konditionierte Substratfläche, wodurch zunächst eine weitestgehend gleiche Schichtoberfläche bzw. -topographie entsteht, lediglich um die Schichtdicke parallel verschoben. Auf diese Weise kann sich auch eine sehr feine Mikroverzahnung zwischen Schicht und Grundwerkstoff bilden. Erst zu einem späteren Zeitpunkt, d. h. mit wachsender Schichtdicke, und mit anderen Gaszusammensetzungen und Spenderstoffangebot läßt sich im Rahmen einer Mehrlagen-Schichttechnik, die Schichttopographie einebnen, wobei je nach Rauheitserfordernis die Mikroschmiertaschen mehr oder weniger tief einzustellen sind.

Etwaige, von der Größe bzw. Ablösungstiefe der Primärkarbide bestimmte Wulste rund um die Mikroschmiertaschen werden im Rahmen der Rauheitseinstellung durch Diamantpolieren auf das erforderliche Rauheitsmaß abgetragen. Eine optimal gestaltete Werkzeugoberfläche z. B. mit einer dreilagigen TiC-TiN-TiCN-CVD-Schicht ist in Fig. 14 schematisch dargestellt.

## Patentansprüche

1. Verfahren zur Oberflächenbehandlung von Werkzeugen aus Werkzeugstahl, in deren Stahlmatrix Primärkarbide eingelagert sind,
**dadurch gekennzeichnet**, daß an der Oberfläche aufgedeckte und/oder angeschnittene und/oder reliefartig vorstehende Primärkarbide unter Bildung einer punktförmig vertieften Oberfläche abgelöst oder gänzlich herausgelöst werden und auf diese Oberfläche eine einoder mehrlagige Hartstoffschicht abgeschieden wird.

2. Verfahren nach Anspruch 1,
**dadurch gekennzeichnet**, daß die Legierungsbestandteile der abgelösten Primärkarbide z. T. auch zum Anlegieren des Vertiefungsgrundes, der Vertiefungswände und der Vertiefungskante verwendet werden und somit Risse und Spalten verschlossen, Kerben und Ecken ausgefüllt sowie Kanten verrundet und auf diese Weise die Vertiefungen gesamtheitlich ausgerundet bzw. ausgeglättet werden.

3. Verfahren nach Anspruch 1,
**dadurch gekennzeichnet**, daß die Primärarbidablösung von der Schichtabscheidung zu einem beliebigen Zeitpunkt überlagert wird, und somit abtragende und aufbauende Stoffumsetzungen unter Beteiligung der Primärkarbidbestandteile ein rasches Auffüllen der muldenförmigen Vertiefungen gestattet und die Schichtoberfläche nur noch geringfügige oder keine Absenkungen über den abgetragenen Primärkarbiden erkennen läßt.

4. Verfahren nach Anspruch 1,
**dadurch gekennzeichnet**, daß nach der Hartstoffabscheidung noch eine relativ weiche, reibungsarme Gleitschicht bestehend aus z. B. MoS₂, hBN abgeschieden wird.

5. Verfahren nach Anspruch 1,
**dadurch gekennzeichnet**, daß gelockerte, gespaltene oder rissige Primärkarbide, insbesondere solche in erhabenen Stellen, vor allem aber in Kanten, so angeätzt bzw. angelöst werden, daß die Spalt- und Rißflächen dekontaminiert und chemisch aktiviert werden, so daß die Schichtabscheidung auch in diesen Rissen und Spalten erfolgen kann, zwecks Rißversiegelung und Wiedereinzementierung der gelockerten Primärkarbide in der Stahlmatrix.

6. Verfahren nach Anspruch 1,
**dadurch gekennzeichnet**, daß nach der Primärkarbidablösung und vor der Schichtabscheidung die Stahlmatrix angeätzt wird und somit eine Mikrorauheit von 2 - 5 µm entsteht, welche die Bildung einer formschlüssigen Mikroverzahnung zwischen Schicht und Stahlmatrix begünstigt, welche die Schubwechselfestigkeit und Schichthaftung verbessert.

7. Verfahren nach Anspruch 6,
**dadurch gekennzeichnet**, daß nach der Primärkarbidablösung und Ätzung, jedoch vor der Schichtabscheidung, die Stahlmatrix thermochemisch so behandelt wird, daß sich Wachstumskeime in den angeschnittenen, äußeren Korngrenzen bilden, welche das Einwachsen der Schicht in die äußeren Korngrenzenbereiche begünstigen und somit eine zusätzliche, formschlüssige Verankerung zwischen Schicht und Stahlmatrix erreicht wird.

8. Verfahren nach Anspruch 1,
**dadurch gekennzeichnet**, daß in einem getrennten Prozeß in einem flüssigen Medium die Primärkarbide galvanisch oder chemisch auf eine vorbestimmte Tiefe von mindestens 1 µm bis zweimal Schichtdicke abgelöst oder herausgelöst werden.

9. Verfahren nach mindestens einem der vorangegangenen Ansprüche,
**dadurch gekennzeichnet**, daß die Hartstoffschicht nach dem CVD-Verfahren abgeschieden wird.

10. Verfahren nach Anspruch 9,
**dadurch gekennzeichnet**, daß unmittelbar vor Beginn der CVD-Beschichtung in ein und demselben thermisch-chemischen Prozeß spezifisch eingestellte Gase die Primärkarbide chemisch und/oder thermisch auf eine vorbestimmte Tiefe von mindestens 1 µm bis zweimal Schichtdicke ablösen und/oder herauslösen.

11. Verfahren nach mindestens einem der vorangegangenen Ansprüche,
**dadurch gekennzeichnet**, daß die Hartstoffschicht nach dem PVD-Verfahren abgeschieden wird.

12. Verfahren nach Anspruch 11,
**dadurch gekennzeichnet**, daß unmittelbar vor der PVD-Hartstoffabscheidung der randnahe Stahlbereich bis zu einer Tiefe von 100-facher Schichtdicke plasmanitriert wird.

13. Werkzeug aus Werkzeugstahl, in dessen Stahlmatrix Primärkarbide eingelagert sind, mit einer nach den Ansprüchen 1 und 10 hergestellten Oberfläche,
**dadurch gekennzeichnet**, daß im randnahen Stahlbereich die Primärkarbide in vorbestimmtem Maß mindestens um 1 µm bis um die doppelte Schichtdicke abgesenkt oder gänzlich herausgelöst sind und die ein- oder mehrlagige CVD-Hartstoffschicht diese Vertiefungen oder Kavernen zusammen mit Bestandteilen der abgelösten Primärkarbide vollkommen ausfüllt und somit punktförmig verteilte, formschlüssige Schichtverankerungen im Grundwerkstoff vorliegen, welche der Hartstoffschicht zusätzliche Schubwechselfestigkeit und Haftfestigkeit verleihen.

14. Werkzeug nach Anspruch 13,
**dadurch gekennzeichnet**, daß die CVD-Schicht über den abgesenkten Karbiden punkt- oder muldenförmige Vertiefungen bildet, welche eine Tiefe von mindestens 1 µm bis zweifache Schichtdicke aufweisen und als Schmiertaschen fungieren.

15. Werkzeug nach Anspruch 13 oder 14,
**dadurch gekennzeichnet**, daß vor allem in Vertiefungen, Kanten und Vorsprüngen gelockerte, angerissene oder angebrochene Primärkarbide entweder abgelöst sind oder durch Bildung der CVD-Schicht, auch unter teilweise Zulegieren der Bestandteile der abgelösten Primärkarbide, diese Risse, Spalten und Brüche zuzemantiert sind und die vorher gelockerten Primärkarbide in der Matrix etwas abgesenkt und wieder fest einzementiert sind.

16. Werkzeug nach mindestens einem der Ansprüche 13 bis 15,
**dadurch gekennzeichnet**, daß die CVD-Schicht nebst den punktförmigen Verankerungen in den Karbidabsenkungen auch eine formschlüssige Mikroverzahnung zwischen CVD-Schicht und Stahlmatrix aufweist, welche die Haftfestigkeit zusätzlich erhöht.

17. Werkzeug nach mindestens einem der Ansprüche 13 bis 16,
**dadurch gekennzeichnet**, daß die CVD-Schicht teilweise in die äußeren Korngrenzenbereiche der Stahlmatrix bis zu einer Tiefe von einer halben Schichtdicke hineinreicht und somit eine zusätzlich formschlüssige Verankerung zwischen Schicht und Stahlmatrix entsteht.

18. Werkzeug aus Werkzeugstahl, in dessen Stahlmatrix Primärkarbide eingelagert sind mit einer nach den Verfahren gemäß den Ansprüchen 1 und 12 hergestellten Oberfläche,
**dadurch gekennzeichnet**, daß im randnahen Stahlbereich die Primärkarbide in vorbestimmtem Maß mindestens um 1 µm bis 4 µm abgesenkt sind und die PVD-Hartstoffschicht diese Vertiefungen auskleidet oder ausfüllt und somit punktförmig verteilte, formschlüssige Schichtverankerungen im Grundwerkstoff vorliegen, welche der PVD-Hartstoffschicht zusätzliche Schubwechselfestigkeit und Haftfestigkeit verleihen.

19. Werkzeug nach Anspruch 18,
**dadurch gekennzeichnet**, daß die PVD-Schicht nebst den punktförmigen Verankerungen in den Karbidabsenkungen auch über eine formschlüssige Mikroverzahnung zwischen Schicht und Stahlmatrix verfügt.

20. Werkzeug nach Anspruch 18 und 19,
**dadurch gekennzeichnet**, daß die PVD-Schicht über den abgesenkten Karbiden punkt- oder muldenförmige Vertiefungen aufweist, welche Schmiertaschen bilden.

21. Werkzeug nach Anspruch 18 bis 20,
**dadurch gekennzeichnet**, daß der randnahe Stahlbereich bis zu einer Tiefe von ca. 100-facher Schichtdicke durch Plasmanitrieren zusätzlich verfestigt ist.

22. Werkzeug nach mindestens einem der Ansprüche 13 bis 21 und mit einer nach dem Verfahren gemäß Anspruch 4 hergestellten Oberfläche,
**dadurch gekennzeichnet**, daß die CVD-Schicht mit einem reibungsarmen, relativ weichen Feststoffgleitfilm z. B. aus Molybdändisulfid (MoS₂) oder hexagonalem Bornitrid (hBN) überzogen ist, welcher sich unter Betriebsbedingung abreibt, jedoch in den punkt- bzw. muldenförmigen Vertiefungen verbleibt und hier als reibungsminderndes Schmierstoffdepot wirkt.
